# EUROPEAN PATENT APPLICATION

(11) **EP 2 674 976 A1**
(43) Date of publication of application: **18.12.2013**
(21) Application number: 13168457.3
(22) Date of filing: 20.05.2013
(51) Int. Cl.: H01L 27/146

(54) **CMOS sensor with backside illumination electronic global shutter control**

(30) Priority: 14.06.2012 US 201213523317
(71) Applicant: Honeywell International Inc., Morristown, NJ 07962-2245 (US)
(72) Inventor: Wang, Ynjiun P., Morristown, NJ 07962-2245 (US); Feng, Chen, Morristown, NJ 07962-2245 (US)
(74) Representative: Houghton, Mark Phillip

(57) **Abstract**

An apparatus (340) comprising an image capture circuit and method for making the same. Electronic devices (418) are formed on a first side (402) of a substrate, each comprising a photo detector (401). A plurality of opaque shields (454) are formed in the substrate at a second side (410) of the substrate corresponding to the electronic devices on the first side of the substrate and each directly opposite one of the electronic devices.

## Description

### Cross-Reference to Related Application

This application contains subject matter which is related to the subject matter of U.S. Patent No. 13/523,317, entitled "CMOS SENSOR WITH BACKSIDE ILLUMINATION ELECTRONIC GLOBAL SHUTTER CONTROL", which is assigned to the same assignee as this application and which is hereby incorporated herein by reference in its entirety.

### BACKGROUND OF THE INVENTION

### Technical Field

The present invention relates to CMOS image sensors. More particularly, the present invention relates to a novel global shutter control structure for backside illuminated CMOS image sensors.

### Background Information

An image sensor, or pixel, is a semiconductor device that collects incoming light energy (photons) and converts a quantity of collected light energy into an electrical signal proportional to the amount, or intensity, of light energy collected. In an image sensor with a storage node, a capacitor is typically used to temporarily store an electric charge corresponding to the magnitude of collected light energy. A global shutter CMOS image sensor employs several transistors in a control circuit for each pixel.

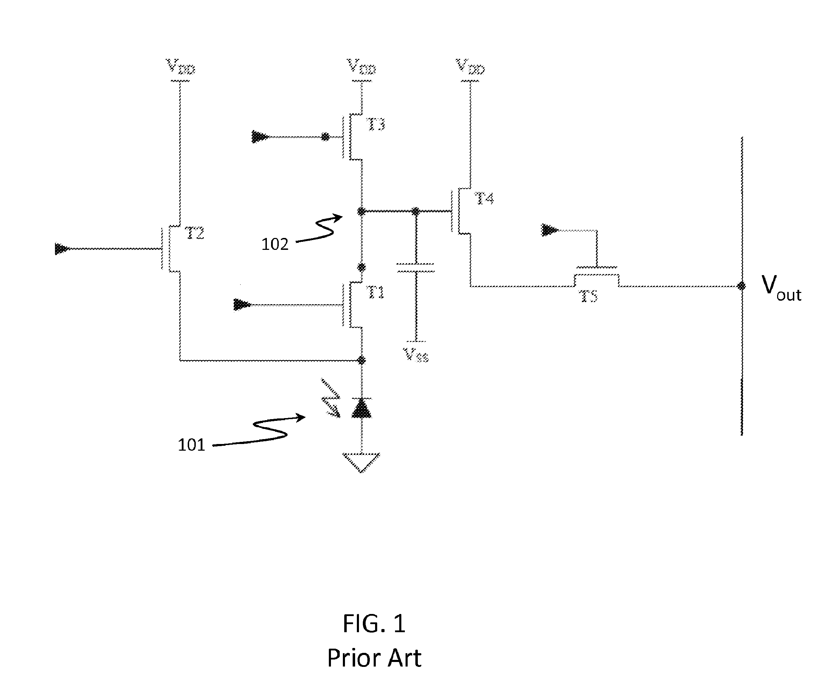

With reference to Fig. 1, there is illustrated a conventional pixel circuit. A first transistor T1 is used to transfer electric charge generated from the collection of light energy in the photo detector (photodiode) 101 to a floating diffusion (capacitor), or storage node 102. A second transistor T2 is used to reset the photo detector node to a desired voltage level for a subsequent exposure. A third transistor T3 resets the storage node to a desired voltage level. A fourth transistor T4, configured as a source follower amplifier, amplifies the charge collected at the storage node. The storage nodes operates as the gate of the source follower for signaling image processing circuitry (not shown) attached to the pixel array. A fifth transistor T5 is switched to select the particular pixel for reading out its stored charge, e.g. Column Out or Vout. Thus, light of various wavelengths is sensed by the photodiode, and thereafter the amount of sensed photogenerated charges are transferred to the floating diffusion node, a gate of the drive transistor, and is output as an electrical signal at an output terminal Vout or Column Out.

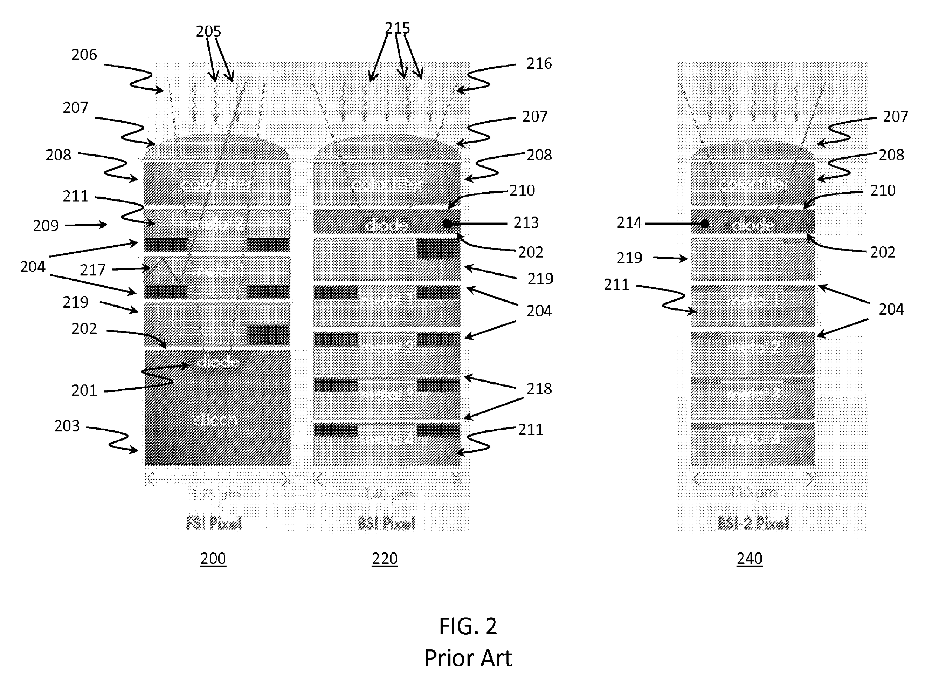

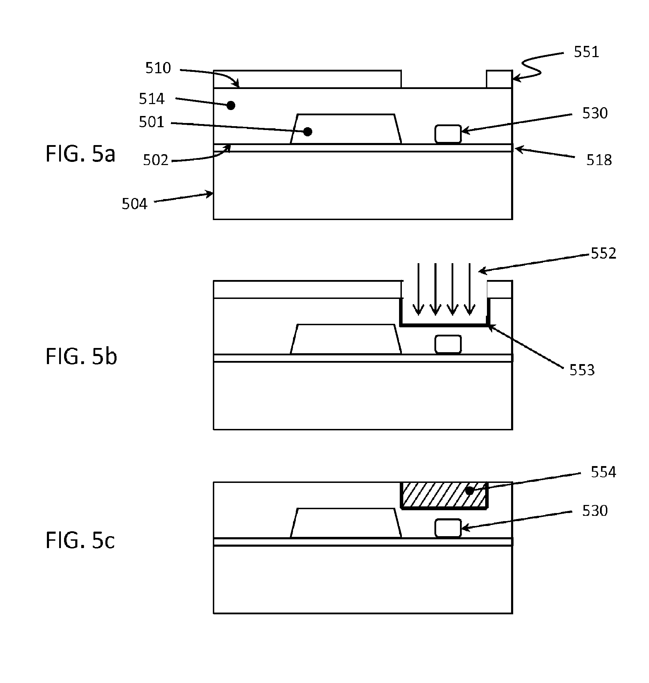

An image sensor is typically fabricated using semiconductor manufacturing processes on a silicon wafer. Generally, a CMOS pixel circuit is manufactured in an array of millions of pixels for capturing digital images. Referring to Figure 2, there is illustrated both a prior art Frontside Illumination (FSI) structure and two prior art versions of Backside Illumination (BSI) CMOS sensor pixel structures. As is well known, BSI technology achieves a better sensitivity by applying filters and micro lenses to the backside of a pixel (backside of silicon wafer) to collect light therethrough. As shown in the figure, BSI technology inverts the arrangement of metal and pixel/filter/lens layers so that metal and dielectric layers reside below the sensor array, providing the most direct path for light to travel into the pixel which optimizes its fill factor and consequently yields a smaller pixel size compared with an FSI pixel. Referring again to FIG. 2, a pixel 200 having a photo detector (photo diode) 201 is formed by implanting selected dopants on a surface 202 of silicon substrate 203. This surface 202 can be alternatively referred to as a top surface, a front surface, or merely a first surface. As used herein the term "on the substrate" refers to the position of the photo diode within the silicon substrate as shown. Although it may be synonymous to state that the photo diode is "in" the substrate or "at a surface" of the substrate, the term "on" will refer to the position as shown, which implies that the steps to form the photo diode are performed by process steps (such as implanting) directed at the top, or front, surface 202. Similar usage is intended for the metal layer 554 shown in Fig. 5C. The term "over the substrate" will be used herein to refer to devices and/or layers that are not within the silicon substrate. Multi-layered metal interconnections 204, e.g., metal interconnection layers metal 1, metal 2, and, alternatively, metal 3 and metal 4 (shown in BSI pixels 220, 240), are formed over the silicon substrate and are electrically connected (not shown) to each other and to the photodiodes. Metallization layer 219 is typically referred to as metal 0. These conductive pathways carry logic and data signals to and from control circuits for processing image data generated by the pixels. The metallization layers are separated by a layer of silicon dioxide (SiO2) 218. Some of the metal lines 204 can be used as voltage transmission lines for distributing power to the devices formed on the substrate. A lens 207 and optional filter 208 are formed over the topmost metal layer 209 in a frontside process (pixel 200) or, alternatively, over a bottom, or second, side 210 of the silicon substrate in a backside process (pixels 220 and 240).

In the CMOS image sensor 200 of FIG. 2, the photo diode is formed on the front surface of the silicon substrate, and the metal interconnections 204 do not directly obstruct the photodiode of the pixel from light 205 incoming at particular angles 206 relative to the surface of the pixel. Thus, light is transmitted through the lens, filter and dielectric 211 of the metalized layers, and eventually reaches the photodiode. Light pathway 217 is illustrated to show that some light energy does not reach the photodiode in the FSI structure, but would impact the photo diode in the BSI design 220, 240.

An array of CMOS image sensors as shown is typically realized as an array of millions of pixels. If the number exceeds a certain amount, the array becomes too large and so individual pixel size must be reduced. This reduction results in a decreased quantity of captured light energy (photons) per pixel, due to a decreased amount of light directly impinging on each photo diode. The quality of images captured by the array thereby is diminished.

BSI architecture has been developed to compensate for this deterioration in image quality caused by reduced pixel size. Instead of capturing light energy traveling through the layers of the pixel apparatus as shown in pixel 200, light energy traveling through the backside of the pixel apparatus is captured. The BSI pixel apparatuses 220 and 240 illustrate this architecture. The structures 220 and 240 are achieved by thinning the silicon substrate 203 after the metallization layers are deposited, resulting in substrate thickness 213 and 214 Thinning can be performed by a blanket etch process, grinding, or chem-mech polishing techniques. Optional light filters, such as color filters 208, are then formed over a second side 210 of the silicon substrate directly opposite the photo diode to substantially filter light impinging on the photo diode. Micro lenses 207 are then formed over the filters each also directly opposite the photo diode formed on the substrate front side. In a monochrome apparatus the color filters are typically not included. Other types of filters may also be used for filtering light of various wavelengths. Thus, the photo diode captures light energy that impinges thereon through the second side of the silicon substrate. This structure allows more light energy 215 to reach the photodiode 201 from a wider angle 216 due to the absence of metalized layers that would otherwise obstruct the photo diode, and so facilitates reducing individual pixel size (1.4um) without loss of image quality. The pixel apparatus 240 illustrates an additional reduction in pixel size (1.1um) using a smaller dimension fabrication process. This reduction in a BSI pixel size without image quality deterioration is achievable because the metallization layers do not obstruct incoming light energy from impinging on the photo diode. The BSI architecture serves to maximize a quantity of light captured by the photo diode, wherein the light first passes through the second side of the thinned silicon substrate rather than the first side as in the FSI architecture. Since the metal interconnection is formed over a first side of the photodiode, the backside pixel area can be increased to improve image capture characteristics of the image sensor as well as fill factor. When fabricating the BSI CMOS image sensor, the backside of the silicon substrate is thinned from approximately 700um to a thickness ranging from approximately 1.5um to approximately 3um. The backside may be grinded, polished, or etched to achieve this thickness.

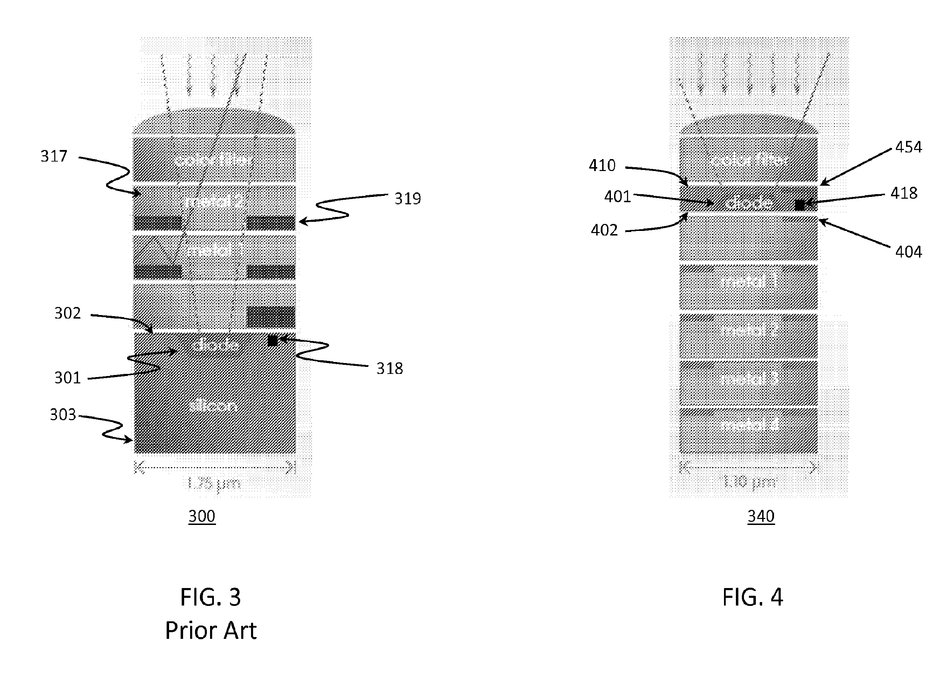

Referring to FIG. 3, a conventional FSI global shutter pixel apparatus 300 is formed with a photo diode 301 on a front surface 302 of a silicon substrate 303 as in the pixel apparatus 200. A capacitor 318 is also formed on the front surface of the silicon substrate and is shielded by opaque metal shield 319 in the metal 2 layer formed over the silicon substrate. The metal 2 layer is comprised of the metal shield 319 and dielectric 317. Metal shield 319 can optionally be utilized, in addition to shielding, as a conductor for transmitting power or data signals to devices formed on the substrate. In general, the metallization layers each comprise metal conductors and dielectric material, wherein the metal lines serve as shielding, power lines or signal carrying lines. The opaque shield facilitates a global shutter feature wherein all pixels in an imaging circuit array are exposed substantially simultaneously to capture an image and transfer respective pixel charges to a shielded capacitor (storage node). Undesired light energy is prevented from reaching the capacitor (storage) node, thereby avoiding disrupting the temporarily stored charges. As before, metallization layers for carrying data and control signals are disposed over the photodiode, optional filters are formed over the top metal layer, and a lens is formed over the optional filter.

A traditional CMOS global shutter sensor consumes 5 to 6 transistors per pixel. Thus, it requires a relatively large pixel size to implement. For a CMOS sensor, with a target pixel size of 1.75um to 2.2um, it is almost impossible to layout 5 to 6 transistors per pixel and still provide a large enough pixel fill factor to yield good signal-to-noise ratio (SNR). The size of the pixel structure cannot be further reduced without modifying the pixel architecture because of the number of transistors required to implement it. The more transistors per pixel the more metal is needed to connect them, which, in turn, reduces an amount of light that reaches the photo diode and, thereby, deteriorates image quality.

Thus, a need exists for a BSI global shutter CMOS image sensor, and a method of making such CMOS image sensors, having greater density and more efficient fill factors. It is desirable to develop methods for building a CMOS architected BSI global shutter mechanism. The present invention is directed to reducing pixel size using BSI fabrication methods combined with a global shutter pixel structure.

### SUMMARY OF THE INVENTION

The present invention satisfies the need for a global shutter architecture and method of fabrication that achieves acceptable fill factor at high pixel resolution. One of the preferred embodiments is to build an opaque shielded (metal layer) storage (capacitor) area by adding a metal layer on top of a BSI CMOS sensor architecture. The current invention leverages the BSI technology and adds a metal layer on top of the BSI pixel to form an opaque shielded storage area (capacitor) for an electronic global shutter pixel design.

In accordance with a preferred embodiment of the present invention, there is provided a method comprising providing a substrate having a first (front) side and a second (bottom) side. A plurality of electronic devices are formed using convention processing techniques on the first side of the substrate. Metallization layers comprising dielectric and conductive interconnect signal lines are electrically connected to the electronic devices for transmitting image data to adjacent processing circuits, and are also formed over the first side of the silicon substrate over the electronic devices. A plurality of opaque shields are formed on a second side of the silicon substrate corresponding to the electronic devices on the first side of the substrate. Each of the opaque shields is disposed directly opposite one of the electronic devices on the first side of the substrate. The formation of the electronic devices comprises forming storage nodes therein, and the opaque shields are each disposed on the second side of the substrate directly opposite one of the electronic devices. The storage node in each of the electronic devices is typically a capacitor and the opaque shields are typically formed from an aluminum metal layer. While the interconnect signal lines transmit data and logic signals, the metal layer is unconnected to the signal lines. A photo detector is also formed in each of the electronic devices and is electrically connected to a corresponding one of the storage nodes. To facilitate light transmission through the second side of the substrate, the substrate is thinned such as by chemical mechanical grinding or by etching. The metal layer is formed by etching portions of the second side of the thinned substrate and depositing a dioxide liner followed by aluminum therein. Optional light filters are each formed directly opposite one of the photo detectors on the first side of the substrate. Micro lenses are then formed over the second side of the substrate, and over the light filters if they are present, each directly opposite one of the photo detectors on the first side of the substrate. Typically, the light filters comprise color filters but can include other types of filters. Opaque shields are typically formed on the first side of the substrate adjacent the storage capacitor and each is normally directly opposite at least a portion of one of the opaque shields on the second side of the substrate. The formation of electronic devices on the first side of the substrate typically comprises an implant step directed at the first side of the substrate, and the formation of opaque shields on the second side of the substrate comprises etching the second side of the substrate and then depositing aluminum or another stable metal in the etched portion.

The present invention provides, in a second aspect, an image capture apparatus such as a digital still camera, a digital video camera, a desktop scanner, a hand held scanner, a cell phone, or a copier. The apparatus includes a substrate having a plurality of pixel regions on a first side of the substrate for capturing image data and at least one electric circuit over the plurality of pixel regions electrically connected to the pixel regions for transmitting the captured image data. Opaque shields on a second side of the substrate are each disposed opposite a portion of one of the pixel regions on the first side of the substrate. Lenses, also over the second side of the substrate, are each disposed opposite one of the pixel regions on the first side of the substrate. Optional light filters, if present, such as color filters or other filters, are each disposed over the second side of the substrate between one of the pixel regions and one of the lenses. The pixel regions each comprise a photo detector, for collecting light energy and for generating a charge in response, and a storage node electrically connected to the photo detector for storing the charge. A plurality of opaque shields over the first side of the substrate are each disposed over a portion of one of the pixel regions and each is disposed directly opposite at least a portion of the opaque shields on the second side of the substrate. The opaque shields are each for blocking undesired light energy from impinging on a portion of a corresponding pixel region. A shutter control circuit is electrically connected to all of the pixel regions for simultaneously activating all of the pixel regions to collect light energy impinging thereon and to transfer the charge generated thereby to their corresponding storage nodes.

The present invention provides, in a third aspect, a pixel apparatus comprising a photo diode and a storage node connected thereto formed on a first side of a substrate. An electric circuit is formed over the first side of the substrate and is electrically connected to the storage node. An opaque shield is formed on a second side of the substrate and is disposed directly opposite the storage node on the first side of the substrate. A lens over the second side of the substrate is disposed directly opposite the photo diode. An optional filter can be formed between the second side of the substrate and the lens.

These, and other, aspects, advantages, features, and objects of the present invention will be better appreciated and understood when considered in conjunction with the following description and the accompanying drawings. It should be understood, however, that the following description, while indicating preferred embodiments of the present invention and numerous specific details thereof, is given by way of illustration and not of limitation. For example, the summary descriptions above are not meant to describe individual separate embodiments whose elements are not interchangeable. In fact, many of the elements described as related to a particular embodiment can be used together with, and possibly interchanged with, elements of other described embodiments. Many changes and modifications may be made within the scope of the present invention without departing from the spirit thereof, and the invention includes all such modifications. The figures below are intended to be drawn neither to any precise scale with respect to relative size, angular relationship, or relative position nor to any combinational relationship with respect to interchangeability, substitution, or representation of an actual implementation. Repeating image elements are not all enumerated with duplicate element numbers to maintain clarity in the figures, but their descriptions are evident from descriptions of corresponding enumerated elements.

### BRIEF DESCRIPTION OF THE DRAWINGS

FIG. 1 depicts a prior art pixel circuit.
FIG. 2 illustrates prior art FSI and BSI pixel structures.
FIG. 3 illustrates a prior art FSI global shutter pixel structure.
FIG. 4 illustrates one embodiment of a BSI global shutter pixel structure of the present invention.
FIGs. 5a-c illustrate a fabrication process for forming the BSI global shutter pixel structure shown in Fig. 4.
FIGs. 6a-d illustrate an arrangement of the opaque shields over a portion of an array of pixel regions.

### DETAILED DESCRIPTION OF THE INVENTION

A preferred embodiment of the present invention includes a novel metal deposition step added to a process flow for a BSI CMOS process sequence. A trench processing technique is used to etch portions of the silicon substrate on the backside directly opposite the storage node (capacitor) on the first side. This etching can be controlled to a depth that closely approaches the capacitor on the first side of the substrate which is advantageous because the metal shield deposited in the trench will block more unwanted light from reaching the storage node, thereby requiring less area for the shield. Prior to the etch process, the silicon substrate is thinned such as by blanket etching or grinding the second side of the substrate. Current known process flows for manufacturing backside illumination pixels do not include metal deposition processing on the backside.

One of the preferred embodiments of a global shutter pixel structure of the present invention is shown in Figure 4. This novel structure includes a diode 401 and a capacitor 418 formed on the front surface 402 of the silicon substrate. Novel metal layer 454 is fabricated on the backside 410 of the silicon substrate to form an opaque shield as shown in Figure 4 to shield the capacitor storage area of the pixel from undesired light energy impinging thereon. Fabricated arrays of the pixel structure as shown can be used for image capture in a variety of devices that currently utilize image sensor arrays. For example, digital still cameras, digital video cameras, desktop scanners, hand held scanners, cell phones, and digital copiers all rely upon image sensor arrays for processing digitally captured images.

Referring to Figs. 5a-5c, there is illustrated a preferred embodiment of a fabrication process for the novel metal shield of the BSI CMOS global shutter pixel of the present invention as shown in Fig. 4. Fig. 5a illustrates the pixel structure described above with reference to Fig. 4 but with multiple metallization layers metal 0 through metal 4, indicated as 504, shown without layer details for purposes of clarity in the figure. Silicon dioxide layer 518 separates the metallization layers from the top surface 502 of the silicon substrate. Photo diode 501 and thinned silicon substrate 514 are present. The front side of the silicon substrate 502, back side 510, and capacitor 530 are illustrated, and function as described above. The backside processing proceeds as follows: referring to Fig. 5a, resist 551 is deposited over the backside of the substrate and patterned according to predetermined locations for placement of opaque shielding, i.e. directly opposite the capacitor storage node formed on the front side of the substrate. Alignment features used for vias and bonding pads are also used for aligning the opaque shield regions. Referring to Fig. 5b, trench processing 552 of substrate regions exposed by the resist patterning forms etched regions in the backside surface, followed by formation of a dioxide layer 553 on the substrate in the trench. The dioxide layer is formed, in a preferred embodiment, by chemical vapor deposition. Referring to Fig. 5c, a metal, such as aluminum, is deposited in the etched regions by an evaporation step, followed by polishing, using a chem-mech process, resulting in opaque metal shield 554 formed on a backside surface of the substrate directly opposite the capacitor 530 formed on the front side of the substrate. This is followed by conventional formation of the optional color, or other, filters, described above, over the back side of the substrate opposite each of the photo diode regions. Micro lenses are then conventionally formed over the back side opposite each of the photo diode regions as described above.

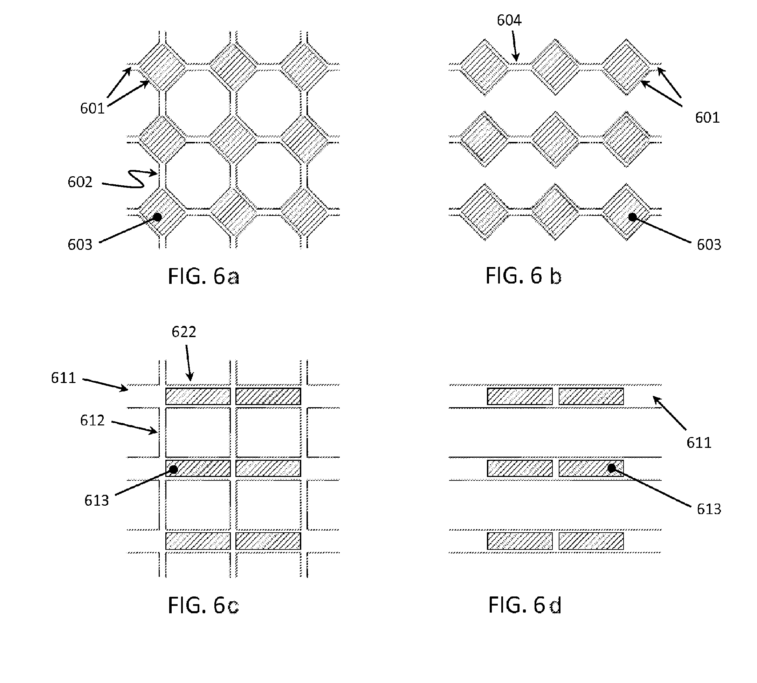

Referring to Figs. 6a-6d, there is illustrated a top view of the opaque shielding formed by the processes illustrated in Figs. 5a-5c. Referring to Figs. 6a and 6b, shielding 601 is formed over storage capacitors 603 (the storage capacitors are beneath the metal shielding in the top view of Figs. 6a and 6b). The opaque metal shields are electrically cross-connected in a grounded grid metallization patterns 602 as shown in Fig. 6a or may be connected with horizontal-only ground connections 604 as shown in Fig. 6b. Referring to Figs. 6c and 6d, shielding 611 is formed over storage capacitors 613 (the storage capacitors are beneath the metal shielding in the top view of Figs. 6c and 6d). The opaque metal shields are electrically cross-connected in a grounded grid metallization pattern 612 as shown in Fig. 6c or may be connected as a horizontal metal shield layer as shown in Fig. 6d.

The metal grid patterns 601, 602, 604, 611, and 612 as shown in Figures 6a-6d further form a horizontal or cross-connected grid to prevent an amount pixel crosstalk wherein a portion of light rays traveling at a sharp angle through a filter of a neighbor pixel are obstructed by the grid line from impinging upon another pixel's photo diode.

While several aspects of the present invention have been described and depicted herein, alternative aspects may be effected by those skilled in the art to accomplish the same objectives. Accordingly, it is intended by the appended claims to cover all such alternative aspects as fall within the true spirit and scope of the invention.

## Claims

1. A method comprising:
providing a substrate, the substrate having a first side and a second side;
forming a plurality of electronic devices on the first side of the substrate;
forming at least one layer comprising a plurality of electric circuits electrically connected to the electronic devices, the at least one layer formed over the first side of the substrate; and
forming a plurality of opaque shields on a second side of the substrate, each of the plurality of opaque shields disposed directly opposite one of the electronic devices formed on the first side of the substrate.

2. The method of claim 1, wherein the forming a plurality of electronic devices comprises forming a storage node in each of the plurality of electronic devices, and wherein the step of forming the plurality of opaque shields comprises disposing each of the opaque shields directly opposite one of the storage nodes.

3. The method of claim 2, wherein the forming a storage node in each of the plurality of electronic devices comprises forming a capacitor, and wherein the step of forming the plurality of opaque shields comprises forming a metal layer.

4. The method of claim 3, wherein the electric circuits carry data signals and wherein the metal layer is unconnected to the electric circuits.

5. The method of claim 2, wherein the forming a plurality of electronic devices further comprises forming a photo detector in each of the plurality of electronic devices, and wherein each photo detector is electrically connected to a corresponding one of the storage nodes.

6. The method of claim 1, further comprising thinning the substrate including removing substrate material from the second side of the substrate before the forming the plurality of opaque shields.

7. The method of claim 6, wherein the forming a plurality of electronic devices comprises forming a photo detector in each of the plurality of electronic devices, and wherein the method further comprises forming a plurality of lenses over the second side of the substrate each directly opposite one of the photo detectors on the first side of the substrate.

8. The method of claim 7, further comprising performing a light filter forming **characterized by** one or more of (a) forming a plurality of light filters before the step of forming the plurality of lenses, the light filters each formed directly opposite one of the photo detectors on the first side of the substrate, and (b) forming a plurality or color filter light filters before the step of forming the plurality of lenses, the color filter light filters each formed directly opposite one of the photo detectors on the first side of the substrate, wherein the step of forming the plurality of lenses comprises forming the plurality of lenses each over one of the light filters.

9. The method of claim 1, wherein the forming a plurality of electronic devices on the first side of the substrate comprises an implanting directed at the first side of the substrate, and wherein the forming a plurality of opaque shields on a second side of the substrate comprises etching the second side of the substrate.

10. An image capture apparatus comprising:
a substrate comprising a plurality of pixel regions on a first side of the substrate for capturing image data;
at least one electric circuit over the plurality of pixel regions electrically connected to the pixel regions for transmitting the captured image data; a plurality of opaque shields on a second side of the substrate each disposed opposite a portion of one of the pixel regions on the first side of the substrate; and
a plurality of lenses over the second side of the substrate each disposed opposite one of the pixel regions on the first side of the substrate.

11. The apparatus of claim 10 further comprising a plurality of light filters over the second side of the substrate each disposed between one of the pixel regions and one of the lenses.

12. The apparatus of claim 11, wherein the light filters comprise color filters.

13. The apparatus of claim 10, wherein each of the pixel regions further comprises a photo detector and a storage node, the photo detector for collecting light energy impinging thereon and for generating a charge in response thereto, the storage node electrically connected to the photo detector for storing the charge generated by the photo detector.

14. The apparatus of claim 13, further comprising a shutter control circuit electrically connected to all of the pixel regions for simultaneously activating all of the pixel regions to collect light energy impinging thereon and to transfer the charge generated thereby to their corresponding storage nodes.

15. A pixel apparatus comprising:
a substrate comprising a photo diode, the photo diode on a first side of the substrate;
a storage node connected to the photo diode, the storage node on the first side of the substrate;
an electric circuit over the first side of the substrate electrically connected to the storage node;
an opaque shield on a second side of the substrate, the second side of the substrate opposite the first side of the substrate, the opaque shield disposed directly opposite the storage node on the first side of the substrate; and
a lens over the second side of the substrate, the lens disposed directly opposite the photo diode on the first side of the substrate.
